# EUROPEAN PATENT SPECIFICATION

(11) **EP 1 493 711 B1**
(45) Date of publication and mention of the grant of the patent: **16.04.2008**
(21) Application number: 03425441.7
(22) Date of filing: 04.07.2003
(51) Int. Cl.: B81B 3/00

(54) **Process for the obtainment of a semiconductor device comprising a suspended micro-system and corresponding device**
Herstellungsverfahren für eine Halbleitervorrichtung mit einem hängenden Mikrosystem und entsprechende Vorrichtung
Procédé de fabrication d'un dispositif semi-conducteur avec une microstructure suspendue et dispositif correspondant

(43) Date of publication of application: 05.01.2005
(73) Proprietor: STMicroelectronics S.r.l., 20041 Agrate Brianza (Milano) (IT)
(72) Inventor: D'Arrigo, Giuseppe, 95030 Sant'Agata li Battiati (CT) (IT); Spinella, Rosario Corrado, 95126 Catania (IT)
(74) Representative: Mittler, Enrico

(56) References cited:
- EP-A- 0 451 992
- EP-A- 0 747 686
- US-A- 6 021 675
- US-A1- 2002 189 350
- ZOU Q ET AL: "DESIGN AND FABRICATION OF SILICON CONDENSER MICROPHONE USING CORRUGATED DIAPHRAGM TECHNIQUE" JOURNAL OF MICROELECTROMECHANICAL SYSTEMS, IEEE INC. NEW YORK, US, vol. 5, no. 3, 1 September 1996 (1996-09-01), pages 197-203, XP000636781 ISSN: 1057-7157
- GRETILLAT M-A ET AL: "Electrostatic polysilicon microrelays integrated with MOSFETs" , MICRO ELECTRO MECHANICAL SYSTEMS, 1994, MEMS '94, PROCEEDINGS, IEEE WORKSHOP ON OISO, JAPAN 25-28 JAN. 1994, NEW YORK, NY, USA,IEEE, PAGE(S) 97-101 XP010207751 ISBN: 0-7803-1833-1 * figure 1 *
- LIEW L-A ET AL: "Modeling of thermal actuation in a bulk-micromachined CMOS micromirror" MICROELECTRONICS JOURNAL, MACKINTOSH PUBLICATIONS LTD. LUTON, GB, vol. 31, no. 9-10, October 2000 (2000-10), pages 791-801, XP004218842 ISSN: 0026-2692

## Description

The present invention refers to a process for the obtainment of a semiconductor device comprising a suspended micro-system, to a device so obtained and its applications.

The suspended micro-systems, defined also semiconductor suspended structures, in the integrated circuits, are generally used in the case in which there is the necessity to provide orthogonal movements of portions of the surface of a crystal of silicon opportunely worked.

The use of such micro-systems can be for example for the realization of micro minor thermally moved.

The obtainment of such structures is a very complex process. The complexity is to be searched in the impossibility to realize sacrificial layers of elevated thickness, for example of about ten micrometres, with the VLSI and ULSI technologies.

Traditionally this drawback is resolved through the use of processes that need for the bulk working (from the back) of the structure in silicon through anisotropy erosion activated by basic solutions as KOH, TMAH or through techniques of wafer bonding, smart cut or using silicon wafer on insulator.

EP 0747686 discloses a method foi forming a diaphragm supported in a cavity, comprising the steps of implanting a P type layer in a substrate, depositing an n-type layer on the substrate, implanting spaced sinkers through the epitaxial layer and into electrical connection with the layer, anodising the substrate to form porous silicon of the sinkers and said layer, oxidizing said porous silicon to form silicon dioxide and etching the silicon dioxide to form the cavity and the diaphragm.

The document of Zou Q et al. « Design and fabrication of silicon condenser microphone using corrugated diaphragm technique", Journal of microelectromechanical systems, IEEE INC, New York, US, vol. 5, no 3, 1 September 1996, pages 197-203, XP000636781, ISSN:1057-7157 discloses a microphone fabricated on a single wafer by use of silicon anisotropic etching and sacrificial layer etching techniques, so that no bonding techniques are required. The introduction of well-performing corrugations has greatly increased the mechanical sensitivities of the microphone diaphragms due to the reduction of the initial stress in the thin films.

In view of the state of the art described, it is an object of the present invention to provide a process for the obtainment of a semiconductor comprising a suspended micro-system of simple realization.

According to the present invention, such an object is achieved by means of a process for the obtainment of a semiconductor device as defined in claim 1.

According to the present invention, such an object is also reached through a device as defined in claim 5.

Thanks to the present invention it is possible to realize a suspended micro-system using a porous layer of silicon as sacrificial oxide and to create in this way a three-dimensional structure below the suspended micro-system, that allows the micro-system to freely move without touching structures near it Advantageously the micro-system results suspended by hinges obtained with the same material of the micro-system that has not been removed. The hinges are connected to walls being formed during the obtainment of the device.

The features and the advantages of the present invention will be made more evident by the following detailed description of a particular embodiment, illustrated as a non-limiting example in the annexed drawings, wherein:
figures 1-9 show the various phases of a process for the obtainment of a semiconductor comprising a suspended micro-system according to the present invention;
figure 10 shows three-dimensionally and partially the microstructure of a mirror obtained through the present invention.

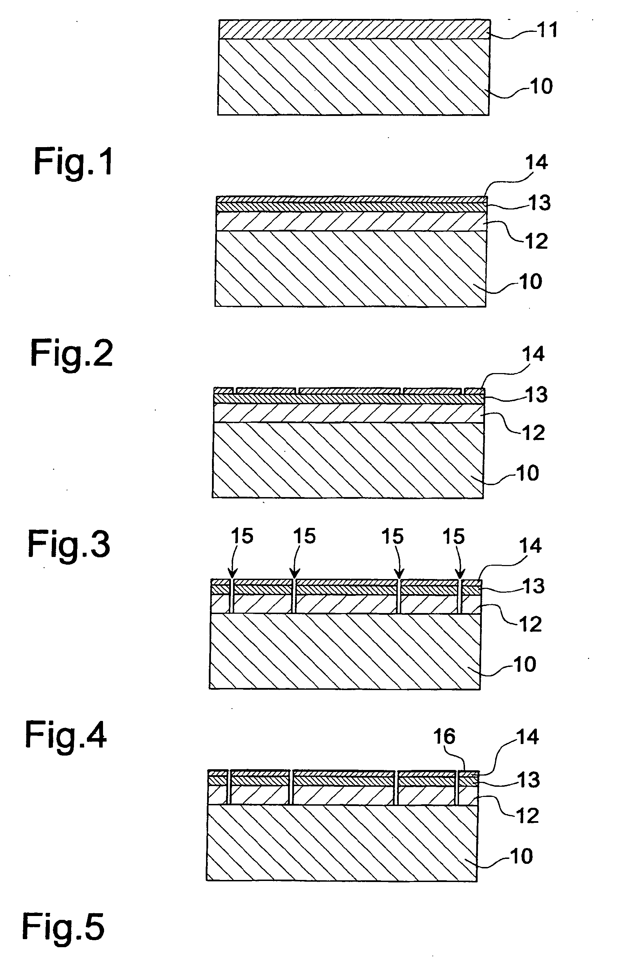

Referring now to figures 1-9, we will now described the various phases of a process for the obtainment of a semiconductor comprising a suspended micro-system according to the present invention.

The substrate 10 is constituted by a wafer Cz (100) of p+ type, with concentrations greater than 5*10¹⁷ B/cm³. As an alternative substrates of p-type can be used with an epitaxy p+ on the surface with a height at least equal to the porous structure 11 to be formed with a further enrichment on the back with the purpose to get a good ohmic contact for the formation of the porous layer 11 during the electrochemical process.

The first step of the process consists in the formation of a porous layer 11 for a height and a porosity desired that can easily be fixed according to the time and the attack conditions (density of current, chemical parameters of the solution, doping concentration).

Curves that allow to appraise the variation of etch rate are available, as silicon thickness transformed by minute and the porosity variation in percentage, on the varying of the current density that flows in the cell of the electrochemical process. For example for the realization of a porous silicon layer 11 of the thickness of 10 micrometres and a 70% porosity 10 minutes are necessary and a current comprised between the 20 and the 40 mA/cm².

Through these processes it is possible to get a porous oxide layer of elevated thickness of the order of about some tens of micrometres.

The following step provides for the oxidation of the porous layer 11, to get an oxidized porous layer 12. The oxidation is obtained at low temperature, around 900 °Cs, for a brief period of 30 minutes, enough for oxidizing the thread-like structure with an average diameter of 50 nm (that can vary in accordance to the process) which constitutes the crystalline skeleton of the porous silicon. Through these processes it is possible to get a porous oxide layer of elevated thickness of the order of about ten micrometres.

After the oxidation process it is possible to close the superficial pores with a thin oxide layer PSG (Phosphorous Silicon Glass) 13, deposed through CVD (Chemical Vapor Deposition).

It is then deposited a polysilicon layer 14, with dimensions between 200 and 400 nm, that will be used as attack mask of the porous oxide 12, given the elevated thickness of the oxidized structure.

If at this point it is necessary to suspend some structures in polysilicon, the porosity in the structure would create notable difficulties since in the processes of wet removal the sacrificial porous oxide, because of the dense net of capillary, would uniformly and totally be corroded under the polysilicon structure, thereby causing the separation not only of some structures to be suspended but also of the anchorages.

The following steps allow to realize some suspended structures in polysilicon by using the oxidized porous layer as sacrificial layer.

A process of deposition and photoengraving of the resist follows. Then a plasma attack of the polysilicon layer 14, effected with a mixture of Cl₂ and HBr followed by a process at high selectivity with respect to the silicon oxide with a mixture of He, O₂ and HBr, is carried out, thereby delimiting portions of the structure as it can be seen in figure 3.

The structure so obtained is used as dry attack mask, with a mixture of CF₄, CHF₃ and Ar, of the oxide layer PSG 13 and of the porous oxide layer 12, up to reach the substrate 10. Some trenches 15 are therefore created as can be seen in figure 4.

At this point the deposition of a nitride layer (Si₃N₄) 16 is executed through LPCVD (Low Pressure Chemical Vapor Deposition) on the whole device of the thickness of around 140 nm, so as to form a similar superficial layer also in the trenches 15, as can be seen in figure 5.

Then a polysilicon layer 17 is deposed through CVD by using a mixture of SiH₄ and AsH₃ at a temperature of 660° C, so as to fill the trenches 15, and a superficial thickness at least equal to half the width of the trenches 15.

The two layers 16 and 17 will uniformly distribute themselves on the whole surface thereby linking to the silicon substrate.

Through this sequence of plasma depositions and attacks it is possible to realize some three-dimensional structures of porous oxide 12, hooked to the substrate 10 and laterally and upwardly sealed by the nitride layer 16 and by the following layers.

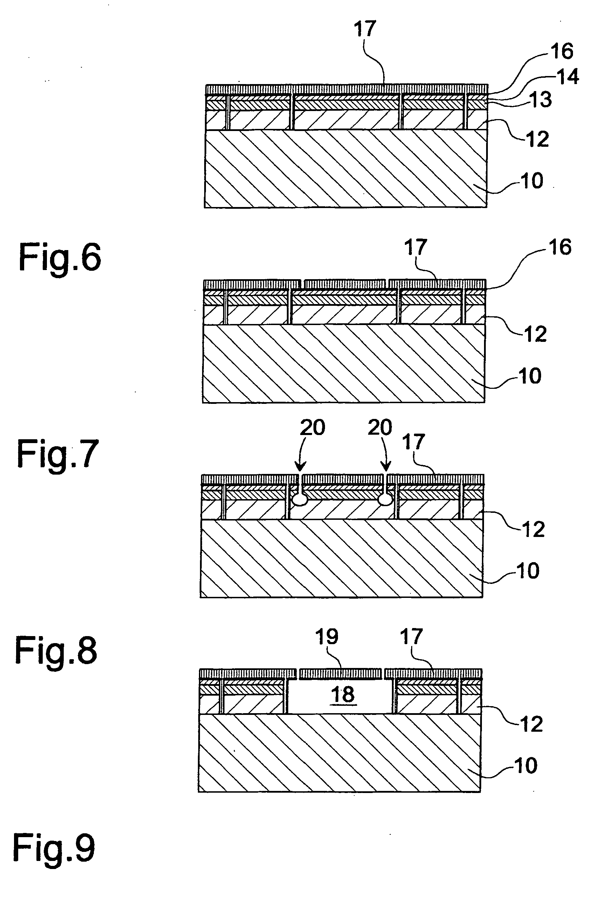

The process continues with the lithography of the polysilicon layer 17 that will be used as mask for the following attack, as from figure 7.

There is then the plasma attack of the triple layer, effected in two phases by using the same procedure for the erosion of the poly-Si 14, that is a plasma attack, effected with a mixture of Cl₂ and HBr followed by a process at high selectivity with respect to the silicon oxide with a mixture of He, O₂ and HBr.

While the nitride layers 16 and the oxide layer PSG 13 are removed with a plasma attack using a mixture of CF₄ and CH₃Ar, as in figure 8. In this way, some zones 20 are created that go beyond the above said three layers and allow the following attack for the removal of the porous oxide 12.

The following wet attack, with a solution containing HF, water solution with a concentration of HF at 10% for a time of 1000 seconds, allows the selective removal of the porous oxide 12, leaving the oxide 13 untouched inside a three-dimensional structure 18, and therefore the obtainment of the suspended structure 19. Such suspended structure 19 is obtained therefore sacrificing (eliminating) the porous oxide 11, and creating an empty space, that is the three-dimensional structure 18, below the suspended structure 19.

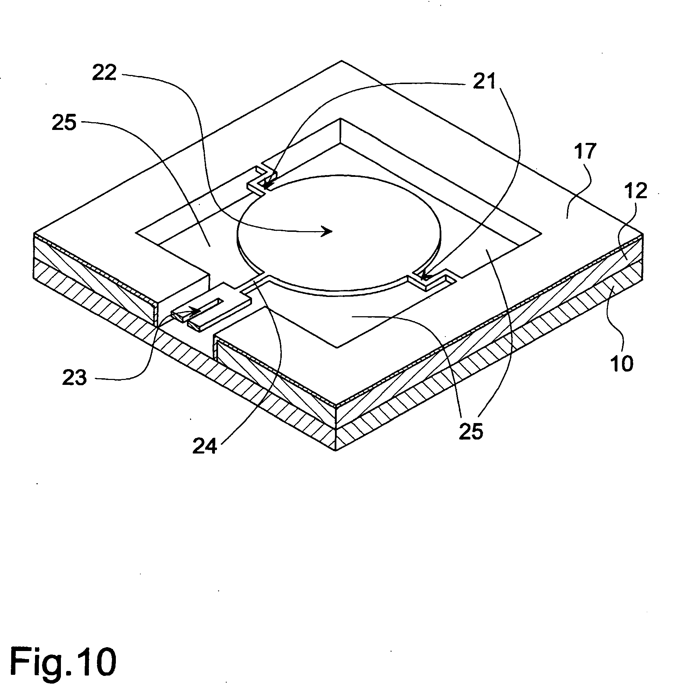

From figure 9 it seems that the suspended structure 19 is not bound to the device because it deals with a section, in reality the mask used for the attack, constituted by the polysilicon layer 17, is to be created so as to obtain a suspended structure 19 bound to the device through opportune hinges (shown in figure 10) obtained through limited portions of structure not removed, according to the specificity of the wanted suspended structure 19.

Figure 10 shows an application of the present invention. In fact, it shows a structure of a device obtained as above described, and the suspended structure 22 here represents a micro mirror having some hinges 21 that allow the suspension and the rotation of the same suspended structure 22. The moving of the micro mirror 22 is effected by a thermo-actuator 23 that for example exploits the thermo-mechanic effect of the bimetallic foils obtained by the different thermal expansion of the materials depending on the variation of the temperature following the passage of current (in our case the materials are the layer of poly-Si and the underlying nitride layer, connected to the micro mirror 22 through the hinge 24).

In this application, the lithographic process of the polysilicon layer 17, that will constitute the attack mask of the nitride layers 16, of polysilicon 14, and of the oxide layer PSG 13, has been effected so that to define three areas 25 to free and to leave, opportunely shaped, the hinges 21 and 24 of hookup of the micro mirror 22 to the device. In the following attack phase the porous layer 12 has been removed in the areas 25 and under the micro mirror 22.

## Claims

1. Process for the obtainment of a semiconductor device comprising a suspended micro-system comprising the steps of:
forming a silicon substrate (10);
forming a porous silicon layer (11) above said substrate (10);
oxidizing said porous layer (12);
depositing on the whole device an oxide layer (13);
depositing above said oxide layer (13) a first polysilicon layer (14);
removing at selected locations said first polysilicon layer (14), said oxide layer (13) and said porous layer (12) for forming trenches (15) down to reach the substrate (10);
depositing on the whole device a nitride layer (16);
depositing on the whole device a second polysilicon layer (17) so as to fill the trenches (15) with a double layer of nitride (16) and polysilicon (17);
removing at selected locations said second polysilicon layer (17), said nitride layer (16), said first polysilicon layer (14), and said oxide layer (13);
removing the oxidised porous layer (12) in the areas (18) made accessible by the preceding removal step and confined by the filled trenches (15) as side-walls.

2. Process according to claim 1 **characterized in that** in said step of removing said first polysilicon layer (14), said oxide layer (13) and said porous layer (12) at selected locations said first polysilicon layer (14) is used as mask in a photo-lithographic process

3. Process according to claim 1 **characterized in that** in said step of removing said second polysilicon layer (17), said nitride layer (16) and said first polysilicon layer (14) at selected locations said second polysilicon layer (17) is used as mask in a photo-lithographic process.

4. Process according to claim 1 **characterized in that** said second polysilicon layer (17), said nitride layer (16) and said first polysilicon layer (14) are removed at selected locations so as to create a suspended structure (19) which is laterally fixed by some portions (22, 24) of said suspended structure (19) not removed.

5. Semiconductor device comprising a suspended micro system (19) fixed to at least two walls through hinges (22, 24), said two walls being placed above a silicon substrate (10) and being constituted by a first nitride layer (16) and a second polysilicon layer (17), said micro system (19) being composed in succession by an oxide layer (13), a first polysilicon layer (14) a nitride layer (16), and said second polysilicon layer (17), said device comprising an empty space (18) below the micro system (19), said empty space (18) having side walls consisting of oxidised porous silicon (12) covered by the first nitride layer (16) and the second polysilicon layer (17).

6. Semiconductor device according to claim 5 **characterized in that** said hinges are composed in succession by an oxide layer (13), a first polysilicon layer (14), a nitride layer (16), and a second polysilicon layer (17).

7. Semiconductor device according to claim 5 **characterized in that** said hinges (22, 24) are constituted by limited portions of material that structurally connect said walls to said suspended structure (19).

8. Semiconductor device according to claim 5, **characterized in that** said micro system (19) is a micro mirror.

9. Semiconductor device according to claim 8, **characterized in that** said micro mirror is moved by means of a thermo-actuator (23).

## Patentansprüche

1. Verfahren zur Erhaltung einer Halbleitervorrichtung, die ein hängendes Mikrosystem aufweist, folgende Schritte aufweisend:
Ausbilden eines Siliciumsubstrats (10);
Ausbilden einer porösen Siliciumschicht (11) über dem Substrat (10);
Oxidieren der porösen Schicht (12);
Abscheiden einer Oxidschicht (13) auf der gesamten Vorrichtung;
Abscheiden einer ersten Polysiliciumschicht (14) über der Oxidschicht (13);
Entfernen der ersten Polysiliciumschicht (14), der Oxidschicht (13) und der porösen Schicht (12) an ausgewählten Stellen, um Rinnen (15) nach unten bis zum Erreichen des Substrats (10) auszubilden;
Abscheiden einer Nitridschicht (16) auf der gesamten Vorrichtung;
Abscheiden einer zweiten Polysiliciumschicht (17) auf der gesamten Vorrichtung, um die Rinnen (15) mit einer Doppelschicht aus Nitrid (16) und Polysilicium (17) zu füllen;
Entfernen der zweiten Polysiliciumschicht (17), der Nitridschicht (16), der ersten Polysiliciumschicht (14) und der Oxidschicht (13) an ausgewählten Stellen;
Entfernen der oxidierten porösen Schicht (12) in den Bereichen (18), die durch den vorangehenden Entfernungsschritt zugänglich gemacht wurden und von den gefüllten Rinnen (15) als Seitenwänden begrenzt werden.

2. Verfahren nach Anspruch 1, **dadurch gekennzeichnet, dass** bei dem Schritt des Entfernens der ersten Polysiliciumschicht (14), der Oxidschicht (13) und der porösen Schicht (12) an ausgewählten Stellen die erste Polysiliciumschicht (14) als Maske in einem fotolithografischen Prozess verwendet wird.

3. Verfahren nach Anspruch 1, **dadurch gekennzeichnet, dass** bei dem Schritt des Entfernens der zweiten Polysiliciumschicht (17), der Nitridschicht (16) und der ersten Polysiliciumschicht (14) an ausgewählten Stellen die zweite Polysiliciumschicht (17) als Maske in einem fotolithografischen Prozess verwendet wird.

4. Verfahren nach Anspruch 1, **dadurch gekennzeichnet, dass** die zweite Polysiliciumschicht (17), die Nitridschicht (16) und die erste Polysiliciumschicht (14) an ausgewählten Stellen entfernt werden, um eine Hängestruktur (19), die durch gewisse nicht entfernte Teile (22, 24) der Hängestruktur (19) seitlich befestigt ist, zu schaffen.

5. Halbleitervorrichtung, aufweisend ein hängendes Mikrosystem (19), das durch Gelenke (22, 24) an mindestens zwei Wänden befestigt ist, wobei die zwei Wände über einem Siliciumsubstrat (10) angebracht sind und von einer ersten Nitridschicht (16) und einer zweiten Polysiliciumschicht (17) gebildet werden, wobei das Mikrosystem (19) in Aufeinanderfolge von einer Oxidschicht (13), einer ersten Polysiliciumschicht (14), einer Nitridschicht (16) und der zweiten Polysiliciumschicht (17) aufgebaut ist, wobei die Vorrichtung unter dem Mikrosystem (19) einen leeren Raum (18) aufweist, wobei der leere Raum (18) Seitenwände hat, die aus oxidiertem porösen Silicium (12), bedeckt von der ersten Nitridschicht (16) und der zweiten Polysiliciumschicht (17), bestehen.

6. Halbleitervorrichtung nach Anspruch 5, **dadurch gekennzeichnet, dass** die Gelenke in Aufeinanderfolge durch eine Oxidschicht (13), eine erste Polysiliciumschicht (14), eine Nitridschicht (16) und eine zweite Polysiliciumschicht (17) aufgebaut sind.

7. Halbleitervorrichtung nach Anspruch 5, **dadurch gekennzeichnet, dass** die Gelenke (22, 24) von begrenzten Materialbereichen, die die Wände mit der Hängestruktur (19) strukturell verbinden, gebildet werden.

8. Halbleitervorrichtung nach Anspruch 5, **dadurch gekennzeichnet, dass** das Mikrosystem (19) ein Mikrospiegel ist.

9. Halbleitervorrichtung nach Anspruch 8, **dadurch gekennzeichnet, dass** der Mikrospiegel mittels eines Thermo-Betätigungselements (23) bewegt wird.

## Revendications

1. Procédé d'obtention d'un dispositif semiconducteur comprenant un microsystème suspendu comprenant les étapes de :
formation d'un substrat de silicium (10) ;
formation d'une couche de silicium poreuse (11) sur ledit substrat (10) ;
oxydation de ladite couche poreuse (12) ;
dépôt sur tout le dispositif d'une couche d'oxyde (13) ;
dépôt au-dessus de ladite couche d'oxyde (13) d'une première couche de polysilicium (14) ;
retrait en des endroits choisis de ladite première couche de polysilicium (14), ladite couche d'oxyde (13) et ladite couche poreuse (12) pour former des tranchées (15) qui descendent jusqu'au substrat (10);
dépôt sur tout le dispositif d'une couche de nitrure (16) ;
dépôt sur tout le dispositif d'une deuxième couche de polysilicium (17) afin de remplir les tranchées (15) d'une double couche de nitrure (16) et de polysilicium (17) ;
retrait en des endroits choisis de ladite deuxième couche de polysilicium (17), ladite couche de nitrure (16), ladite première couche de polysilicium (14) et ladite couche d'oxyde (13) ;
retrait de la couche poreuse oxydée (12) dans les zones (18) rendues accessibles par l'étape de retrait précédente et délimitées par les tranchées (15) remplies qui forment des parois latérales.

2. Procédé selon la revendication 1, **caractérisé en ce que**, dans ladite étape de retrait de ladite première couche de polysilicium (14), ladite couche d'oxyde (13) et ladite couche poreuse (12) à des endroits choisis, ladite première couche de polysilicium (14) est utilisée comme masque dans un procédé photolithographique.

3. Procédé selon la revendication 1, **caractérisé en ce que**, dans ladite étape de retrait de ladite deuxième couche de polysilicium (17), ladite couche de nitrure (16) et ladite première couche de polysilicium (14) à des endroits choisis, ladite deuxième couche de polysilicium (17) est utilisée comme masque dans un procédé photolithographique.

4. Procédé selon la revendication 1, **caractérisé en ce que** ladite deuxième couche de polysilicium (17), ladite couche de nitrure (16) et ladite première couche de polysilicium (14) sont retirées en des endroits choisis afin de créer une structure suspendue (19) qui est fixée latéralement par certaines parties (22, 24) de ladite structure suspendue (19) non retirées.

5. Dispositif semiconducteur comprenant un microsystème suspendu (19) fixé à au moins deux parois par des articulations (22, 24), lesdites deux parois étant placées au-dessus d'un substrat de silicium (10) et constituées par une première couche de nitrure (16) et une deuxième couche de polysilicium (17), ledit microsystème (19) étant composé d'une succession d'une couche d'oxyde (13), une première couche de polysilicium (14), une couche de nitrure (16) et ladite deuxième couche de polysilicium (17), ledit dispositif comprenant un espace vide (18) sous le microsystème (19), ledit espace vide (18) ayant des parois latérales constituées de silicium poreux oxydé (12) couvert par la première couche de nitrure (16) et la deuxième couche de polysilicium (17).

6. Dispositif semiconducteur selon la revendication 5, **caractérisé en ce que** lesdites articulations sont composées d'une succession d'une couche d'oxyde (13), une première couche de polysilicium (14), une couche de nitrure (16) et une deuxième couche de polysilicium (17).

7. Dispositif semiconducteur selon la revendication 5, **caractérisé en ce que** lesdites articulations (22, 24) sont constituées par des parties limitées de matériau qui relient structurellement lesdites parois à ladite structure suspendue (19).

8. Dispositif semiconducteur selon la revendication 5, **caractérisé en ce que** ledit microsystème (19) est un micromiroir.

9. Dispositif semiconducteur selon la revendication 8, **caractérisé en ce que** ledit micromiroir est mis en mouvement au moyen d'un actionneur thermique (23).
